# EUROPEAN PATENT APPLICATION

(11) **EP 4 633 304 A1**
(43) Date of publication of application: **15.10.2025**
(21) Application number: 23909319.8
(22) Date of filing: 07.09.2023
(51) Int. Cl.: H05K 7/20

(54) **ELECTRONIC DEVICE**

(30) Priority: 27.12.2022 CN 202211680930
(71) Applicant: xFusion Digital Technologies Co., Ltd., Zhengzhou, Henan 450000 (CN)
(72) Inventor: JIA, Hui, Zhengzhou, Henan 450000 (CN); WANG, Guangjing, Zhengzhou, Henan 450000 (CN)
(74) Representative: MERH-IP Matias Erny Reichl Hoffmann Patentanwälte PartG mbB
(86) International application number: PCT/CN2023/117441
(87) International publication number: WO 2024/139381

(57) **Abstract**

The present application provides an electronic device. The electronic device includes: a first heat dissipation system, including a first cold plate and a first heat dissipation pipe, where the first heat dissipation pipe is connected to the first cold plate and is configured for coolant to flow, and the first cold plate is configured to dissipate heat from a first heating element; a second heat dissipation system, including a second cold plate and a second heat dissipation pipe, where one end of the second heat dissipation pipe is connected to one end of the second cold plate, the other end of the second heat dissipation pipe is connected to the other end of the second cold plate, the second heat dissipation pipe is configured for the coolant to flow through circulation, and the second cold plate is configured to dissipate heat from a second heating element; and a coolant distribution unit, where the first heat dissipation pipe and the second heat dissipation pipe are connected to the coolant distribution unit, and the coolant distribution unit is configured to cool the coolant in the first cold plate and the second cold plate through circulation; where the second cold plate is made of a flexible material, and power of the first heating element is greater than power of the second heating element. Thus, cost of heat dissipation for all heating elements in the electronic device is reduced.

## Description

This application claims priority to Chinese Patent Application No. 202211680930.7 filed with the China National Intellectual Property Administration on December 27, 2022, entitled "ELECTRONIC DEVICE", which is incorporated herein by reference in its entirety.

### TECHNICAL FIELD

The present application relates to the field of heat dissipation technology, and in particular to an electronic device.

### BACKGROUND

With the advent of the network and data era, electronic devices used for network communication, data processing, and data storage have increased significantly, such as communication devices (such as base stations and switches), computer devices (such as servers and hosts), and so on. And these devices have strict temperature requirements. Since the devices generate heat during operation, heat sinks are generally integrated in these devices.

Currently, an increasing number of electronic devices only employ liquid cooling systems to dissipate heat from all heating elements in the electronic devices. However, the cost of employing only liquid cooling systems to dissipate heat for all heating elements in the electronic devices is high.

### SUMMARY

Embodiments of the present application provide an electronic device, which can reduce the cost of heat dissipation for heating elements in the electronic device.

Embodiments of the present application provide an electronic device, including:
a first heat dissipation system, including a first cold plate and a first heat dissipation pipe, where the first heat dissipation pipe is connected to the first cold plate and is configured for coolant to flow, and the first cold plate is configured to dissipate heat from a first heating element;
a second heat dissipation system, including a second cold plate and a second heat dissipation pipe, where one end of the second heat dissipation pipe is connected to one end of the second cold plate, the other end of the second heat dissipation pipe is connected to the other end of the second cold plate, the second heat dissipation pipe is configured for the coolant to flow through circulation, and the second cold plate is configured to dissipate heat from a second heating element; and
a coolant distribution unit, where the first heat dissipation pipe and the second heat dissipation pipe are connected to the coolant distribution unit, and the coolant distribution unit is configured to cool the coolant in the first cold plate and the second cold plate through circulation;
where the second cold plate is made of a flexible material, and power of the first heating element is greater than power of the second heating element.

The embodiments of the present application ensure heat dissipation for both high-power and low-power heating elements by connecting the first heat dissipation system and the second heat dissipation system through the coolant distribution unit. In addition, by using the cold plate made of the flexible material for the low-power heating elements, cost of heat dissipation for heating elements in the electronic device is reduced.

In a possible implementation, the coolant distribution unit is located on a side adjacent to a liquid inlet of the first heat dissipation pipe.

In this way, both the first heat dissipation system and the second heat dissipation system can receive initial coolant which does not dissipate heat for any heat dissipation system and has the lowest temperature.

In a possible implementation, the coolant distribution unit includes:
a power mechanism, configured to convey the coolant in the second heat dissipation pipe through circulation; and
a heat exchanger, configured to cool the coolant in the first cold plate and the second cold plate through circulation.

In this way, the coolant in the second heat dissipation system circulates.

In a possible implementation, the electronic device further includes a liquid supply mechanism, connected to the second heat dissipation system, and configured to store the coolant and replenish the coolant to the second heat dissipation system when the coolant in the second heat dissipation system is reduced.

This ensures that there is sufficient coolant in the second cold plate.

In a possible implementation, the liquid supply mechanism further includes:
a water storage module, connected to the second heat dissipation pipe by a connection pipe, and configured to store the coolant and replenish the coolant to the second heat dissipation system through the connection pipe; and
a one-way valve, configured to control a flow direction of the coolant in the connection pipe, where the flow direction of the coolant in the connection pipe is from the water storage module to the second heat dissipation system.

This ensures that there is sufficient coolant in the second cold plate.

In a possible implementation, the coolant distribution unit includes a first liquid inlet, a second liquid inlet, a first liquid outlet, and a second liquid outlet;
the first heat dissipation pipe passes through the coolant distribution unit through the first liquid inlet and the first liquid outlet, and is in communication with the coolant distribution unit; and
the second heat dissipation pipe passes through the coolant distribution unit through the second liquid inlet and the second liquid outlet, and is in communication with the coolant distribution unit.

In a possible implementation, the coolant distribution unit includes a first liquid inlet and a first liquid outlet, and the first heat dissipation pipe includes:
a first pipe section, connected to the first liquid inlet of the coolant distribution unit, serving as a liquid inlet end of the first heat dissipation system;
a second pipe section, connected to the first liquid outlet of the coolant distribution unit and a liquid inlet end of the first heating element; and
a third pipe section, connected to a liquid outlet end of the first heating element, serving as a liquid outlet end of the first heat dissipation system.

In a possible implementation, the coolant distribution unit includes a second liquid inlet and a second liquid outlet, and the second heat dissipation pipe includes:
a fourth pipe section, connected to the second liquid inlet; and
a fifth pipe section, connected to the second liquid outlet.

### BRIEF DESCRIPTION OF DRAWINGS

FIG. 1 is a structural cross-sectional view of an electronic device in a front view direction according to an embodiment of the present application;
FIG. 2 is an architectural diagram of a heat dissipation system of an electronic device according to an embodiment of the present application;
FIG. 3 is a structural cross-sectional view of another electronic device in a front view direction according to an embodiment of the present application;
FIG. 4 is a schematic diagram of a limiting structure of a second heating element according to an embodiment of the present application;
FIG. 5 is a schematic diagram of a connection relationship of each component in a heat dissipation system of an electronic device according to an embodiment of the present application;
FIG. 6 is a structural diagram of a coolant distribution unit according to an embodiment of the present application;
FIG. 7 is an architectural diagram of another heat dissipation system of an electronic device according to an embodiment of the present application; and
FIG. 8 is a structural diagram of a heat supply mechanism according to an embodiment of the present application.

### DESCRIPTION OF EMBODIMENTS

The following describes technical solutions in embodiments of the present application with reference to accompanying drawings in the embodiments of the present application.

In description of the present application, orientations or position relationships indicated by terms "center", "up", "down", "front", "rear", "left", "right", "vertical", "horizontal", "top", "bottom", "inside", "outside", or the like are orientations or position relationships shown based on the accompanying drawings, are only for conveniently describing the present application and simplifying the description, do not indicate or imply that indicated apparatuses or elements necessarily have particular orientations or are necessarily constructed and operated at particular orientations, and therefore should not be construed as a limitation to the present application.

In the description of the present application, it should be noted that, unless otherwise specified or limited, the terms "mounted", "interconnected", and "connected" are to be understood in a broad sense, and for example, may be a fixed connection, a detachable connection, an abutting connection, or an integrated connection. For those skilled in the art, the specific meanings of the above terms in the present application can be understood according to specific circumstances.

Furthermore, in the description of the present application, specific features, structures, materials, or characteristics may be combined in any suitable manner in one or more embodiments.

An electronic device includes various heating elements, such as a central processing unit (Central Processing Unit, CPU), a graphics processing unit (Graphics Processing Unit, GPU), a memory, a power supply chip, etc. During operation of the electronic device, the heating elements will generate heat. All heating elements have strict temperature requirements, thus ensuring normal operation of the electronic device.

Currently, heat dissipation methods for the electronic device include air cooling and liquid cooling. In related art, an increasing number of electronic devices only employ liquid cooling systems to dissipate heat from all heating elements in the electronic devices. However, heat sinks in liquid cooling systems are all made of metal, resulting in high cost.

Based on this, the embodiments of the present application provide an electronic device that dissipates heat from heating elements with different powers through different liquid cooling systems. The liquid cooling system with flexible materials is used for lower-power heating elements, thereby reducing cost of liquid cooling.

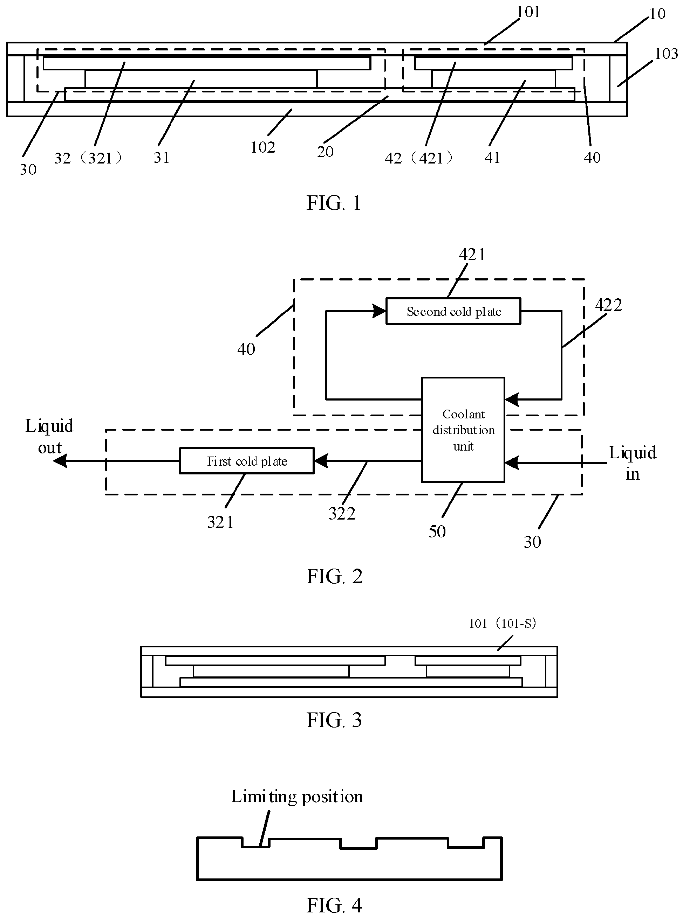

FIG. 1 is a structural cross-sectional view of an electronic device in a front view direction according to an embodiment of the present application. As shown in FIG. 1, the electronic device includes a chassis 10, and a circuit board 20, a first heating element 31, a second heating element 41, a first heat sink 32, and a second heat sink 42 which are disposed in the chassis 10. The first heating element 31 and the first heat sink constitute a first heat dissipation system 30. The second heating element 41 and the second heat sink 42 constitute a second heat dissipation system 40.

The chassis 10 includes an upper cover plate 101, a lower cover plate 102, and a side panel 103. The circuit board 20 is fixed to the lower cover plate 102 of the chassis 10 by a connecting member. The first heating element 31 and the second heating element 41 are disposed on the circuit board 20. The first heat sink 32 includes a first cold plate 321. The first cold plate 321 is disposed opposite to the first heating element 31, fixed to the lower cover plate 102 of the chassis 10 by the connecting member, and configured to absorb heat dissipated by the first heating element 31. The second heat sink 42 includes a second cold plate 421. The second cold plate 421 is disposed opposite to the second heating element 41 and is configured to absorb heat dissipated by the second heating element 41. Here, the connecting member may pass through the circuit board 20 or pass along an outer side of the circuit board 20. It should be noted that connection methods of various components in a structure of the electronic device provided in the embodiment of the present application are exemplary only and are not specifically limited in the present application. Furthermore, the connecting member in the embodiment of the present application is not shown in the figure.

In some embodiments, the electronic device may be a server, a switch, a host, etc., which is not limited in the present application.

In the embodiments of the present application, the electronic device further includes a coolant distribution unit. The coolant distribution unit is configured to drive coolant in the first heat dissipation system and the second heat dissipation system, so that the coolant in the first heat dissipation system and the second heat dissipation system can be circulated and cooled. The following provides a detailed explanation of a connection relationship between the first heat dissipation system, the second heat dissipation system, and the coolant distribution unit in the electronic device.

FIG. 2 is an architectural diagram of a heat dissipation system of the electronic device according to an embodiment of the present application. As shown in FIG. 2, the heat dissipation system of the electronic device provided in the embodiment of the present application includes the first heat dissipation system 30, the second heat dissipation system 40, and a coolant distribution unit 50.

The first heat dissipation system 30 includes the first cold plate 321 and a first heat dissipation pipe 322. The first heat dissipation pipe 322 is connected to the first cold plate 321 and is configured for the coolant to flow. The first cold plate is configured to dissipate heat from the first heating element 31. The first heat dissipation pipe is also configured to connect to an external coolant supply mechanism.

The second heat dissipation system 40 includes the second cold plate 421 and a second heat dissipation pipe 422. One end of the second heat dissipation pipe 422 is connected to one end of the second cold plate 421, and the other end of the second heat dissipation pipe 422 is connected to the other end of the second cold plate 421, thereby forming a circulation loop. In this way, the second heat dissipation pipe 422 is configured for the coolant to flow through circulation, and the second cold plate 421 is configured to dissipate heat from the second heating element. The first heat dissipation pipe 322 and the second heat dissipation pipe 422 are connected to the coolant distribution unit 50. The coolant distribution unit is configured to cool the coolant in the first cold plate 321 and the second cold plate 421 through circulation.

In the embodiment of the present application, to reduce the cost of liquid cooling, the second cold plate is made of a flexible material.

As a possible implementation, the second cold plate is made of a material suitable for printing processing. Before processing, a layout of the second heating element needs to be matched, so that a structure of the second cold plate and the layout of the second heating element are mutually matched.

For example, the second cold plate may be made of a rubber material. In another example, the second cold plate may be made of a plastic material. In a further example, the second cold plate may be a flexible material doped with technological particles.

As a possible implementation, the second cold plate may be a flexible water bag that is capable of containing coolant. In the embodiment of the present application, as shown in FIG. 3, the upper cover plate 101 of the chassis is equivalent to a locking mechanism 101-S of the second cold plate. When the flexible water bag is filled with the coolant, the flexible water bag swells under an action of the coolant. In combination with a limiting position of the second heating element and the upper cover plate, contact between the flexible water bag and the second heating element is achieved. For example, there may be a plurality of second heating elements, and the limiting position of the second heating element may be a groove on the second heating element or a groove between the plurality of the second heating elements. For example, FIG. 4 shows a cross-sectional view of the second heating element with the limiting position.

In the embodiment of the present application, power of the first heating element is greater than power of the second heating element. For example, the first heating element is a component such as a CPU, a GPU, etc. The second heating element is a component such as a memory.

Next, a detailed explanation of a connection relationship between various components in FIG. 2 is provided.

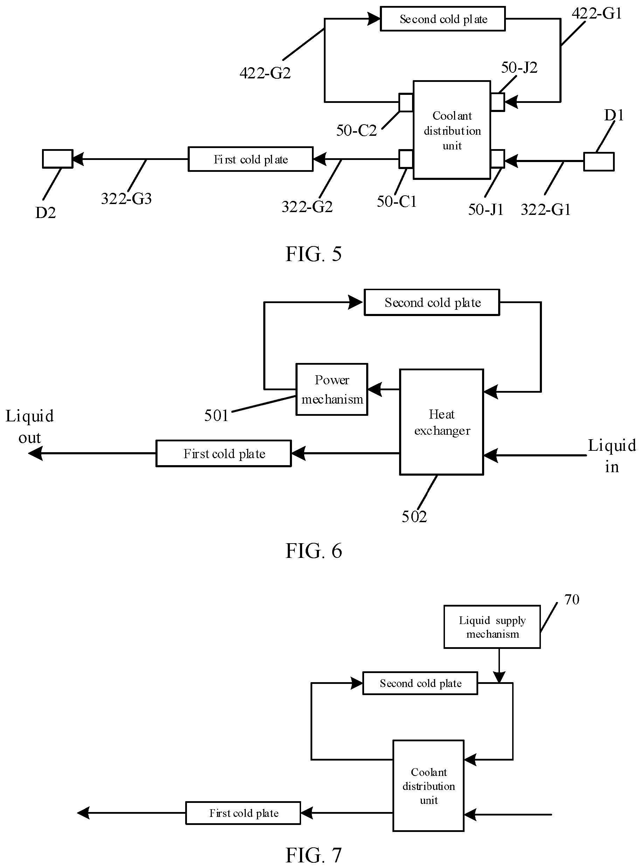

As shown in FIG. 5, the first heat dissipation pipe 322 includes a first pipe section 322-G1, a second pipe section 322-G2, and a third pipe section 322-G3. The coolant distribution unit 50 includes a first liquid inlet 50-J1 and a first liquid outlet 50-C1. The first pipe section 322-G1 is connected to the first liquid inlet 50-J1. The second pipe section 322-G2 is connected to the first liquid outlet 50-C of the coolant distribution unit 50, and is also connected to a liquid inlet end of the first heating element. The third pipe section 322-G3 is connected to a liquid outlet end of the first heating element. Here, the liquid inlet end and the liquid outlet end of the first heating element are not marked, and can be determined based on a flow direction of the coolant in FIG. 5.

As shown in FIG. 5, the second heat dissipation pipe includes a fourth pipe section 422-G1 and a fifth pipe section 422-G2. The coolant distribution unit 50 further includes a second liquid inlet 50-J2 and a second liquid outlet 50-C2. The second heat dissipation pipe and the second cold plate form a loop. The fourth pipe section 422-G1 of the second heat dissipation pipe is connected to the second liquid inlet 50-J2, and the fifth pipe section 422-G2 of the second heat dissipation pipe is connected to the second liquid outlet 50-C2. Thus, the coolant in the second cold plate is cooled at the coolant distribution unit, completing heat dissipation for the second heating element.

In some embodiments, as shown in FIG. 5, the first heat dissipation system includes a liquid inlet end D1 and a liquid outlet end D2. The liquid inlet end D1 of the first heat dissipation system is configured to connect to an end of an external coolant supply. For example, the liquid inlet end D1 may be a quick connector. The liquid outlet end D2 of the second heat dissipation system is configured to connect to the other end of the external coolant supply. For example, the liquid outlet end D2 may be a quick connector. Herein, the quick connector is a connector capable of connecting and disconnecting a liquid path while maintaining a liquid sealing in both connected and disconnected states of the quick connector, supporting pluggable maintenance for individual plate. Operation methods of the quick connector generally include self-locking or blind-mating. The former requires manual coupling and decoupling of two ends of the quick connector, while the latter is operated directly through a chassis slide rail, and has an independent positioning structure.

The above shows the connection relationship between various components. Next, the coolant distribution unit in FIG. 2 is explained in detail.

As shown in FIG. 6, the coolant distribution unit 50 includes a power mechanism 501 and a heat exchanger 502. The power mechanism is configured for the coolant in the second cold plate to flow through circulation and perform heat exchange on the coolant in the second cold plate at the heat exchanger. The heat exchanger is further configured to cool the coolant in the first cold plate through circulation.

As shown in FIG. 6, the power mechanism 501 is mounted on the second heat dissipation pipe. For example, the second liquid inlet 50-J2 of the coolant distribution unit is equipped with the power mechanism, or the second liquid outlet 50-C2 of the coolant distribution unit is equipped with the power mechanism. It should be noted that the power mechanism and the heat exchanger may be an integrated structure or a non-integrated structure, which is not specifically limited in the embodiments of the present application.

In the embodiments of the present application, as shown in FIG. 2, the coolant distribution unit is located on an end adjacent to a liquid inlet of the first heat dissipation pipe.

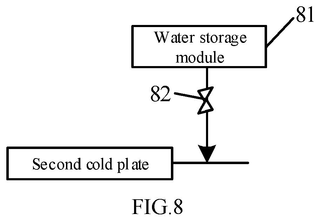

In some embodiments, as shown in FIG. 7, the electronic device further includes a liquid supply mechanism 70. The liquid supply mechanism is connected to the second heat dissipation system, and is configured to store the coolant and replenish the coolant to the second heat dissipation system when the coolant in the second heat dissipation system is reduced. As a possible implementation, as shown in FIG. 8, the liquid supply mechanism includes a water storage module 81 and a one-way valve 82. The water storage module 81 is connected to the second heat dissipation pipe by a connection pipe to store the coolant and replenish the coolant to the second heat dissipation system through the connection pipe. For example, the water storage module may be a water bladder.

The one-way valve 82 is configured to control a flow direction of the coolant in the connection pipe, the flow direction of the coolant in the connection pipe is from the water storage module to the second heat dissipation system.

Finally, it is noted that the above embodiments are only used to illustrate the technical solution of the present application, but not limit the technical solution. Although the present application is described in detail with reference to the above embodiments, those skilled in the art should understand that the technical solution described in the above embodiments can be modified or some of the technical features wherein can be equally substituted. Such modification or substitution does not make the essence of the corresponding technical solution departing from the scope of the technical solution of the embodiments of the present application.

## Claims

1. An electronic device, comprising:
a first heat dissipation system, comprising a first cold plate and a first heat dissipation pipe, wherein the first heat dissipation pipe is connected to the first cold plate and is configured for coolant to flow, and the first cold plate is configured to dissipate heat from a first heating element;
a second heat dissipation system, comprising a second cold plate and a second heat dissipation pipe, wherein one end of the second heat dissipation pipe is connected to one end of the second cold plate, the other end of the second heat dissipation pipe is connected to the other end of the second cold plate, the second heat dissipation pipe is configured for the coolant to flow through circulation, and the second cold plate is configured to dissipate heat from a second heating element; and
a coolant distribution unit, wherein the first heat dissipation pipe and the second heat dissipation pipe are connected to the coolant distribution unit, and the coolant distribution unit is configured to cool the coolant in the first cold plate and the second cold plate through circulation;
wherein the second cold plate is made of a flexible material, and power of the first heating element is greater than power of the second heating element.

2. The electronic device according to claim 1, wherein the coolant distribution unit is located on a side adjacent to a liquid inlet of the first heat dissipation pipe.

3. The electronic device according to claim 1, wherein the coolant distribution unit comprises:
a power mechanism, configured to convey the coolant in the second heat dissipation pipe through circulation; and
a heat exchanger, configured to cool the coolant in the first cold plate and the second cold plate through circulation.

4. The electronic device according to claim 1 or 3, further comprising a liquid supply mechanism, connected to the second heat dissipation system, and configured to store the coolant and replenish the coolant to the second heat dissipation system when the coolant in the second heat dissipation system is reduced.

5. The electronic device according to claim 4, wherein the liquid supply mechanism comprises:
a water storage module, connected to the second heat dissipation pipe by a connection pipe, and configured to store the coolant and replenish the coolant to the second heat dissipation system through the connection pipe; and
a one-way valve, configured to control a flow direction of the coolant in the connection pipe, wherein the flow direction of the coolant in the connection pipe is from the water storage module to the second heat dissipation system.

6. The electronic device according to claim 1, wherein the coolant distribution unit comprises a first liquid inlet, a second liquid inlet, a first liquid outlet, and a second liquid outlet;
the first heat dissipation pipe passes through the coolant distribution unit through the first liquid inlet and the first liquid outlet, and is in communication with the coolant distribution unit; and
the second heat dissipation pipe passes through the coolant distribution unit through the second liquid inlet and the second liquid outlet, and is communication with the coolant distribution unit.

7. The electronic device according to claim 1, wherein the coolant distribution unit comprises a first liquid inlet and a first liquid outlet, and the first heat dissipation pipe comprises:
a first pipe section, connected to the first liquid inlet of the coolant distribution unit, serving as a liquid inlet end of the first heat dissipation system;
a second pipe section, connected to the first liquid outlet of the coolant distribution unit and a liquid inlet end of the first heating element; and
a third pipe section, connected to a liquid outlet end of the first heating element, serving as a liquid outlet end of the first heat dissipation system.

8. The electronic device according to claim 1, wherein the coolant distribution unit comprises a second liquid inlet and a second liquid outlet, and the second heat dissipation pipe comprises:
a fourth pipe section, connected to the second liquid inlet; and
a fifth pipe section, connected to the second liquid outlet.
